# EUROPEAN PATENT APPLICATION

(11) **EP 1 102 524 A1**
(43) Date of publication of application: **23.05.2001**
(21) Application number: 00921050.1
(22) Date of filing: 27.04.2000
(51) Int. Cl.: H05K 3/42, H05K 3/46

(54) **DOUBLE-SIDED PRINTED WIRING BOARD AND METHOD FOR MANUFACTURING MULTILAYER PRINTED WIRING BOARD HAVING THREE OR MORE LAYERS**

(30) Priority: 06.05.1999 JP 12540099
(71) Applicant: Mitsui Mining & Smelting Co., Ltd., Tokyo 141-8584 (JP)
(72) Inventor: HIRASAWA, Yutaka, Mitsui Mining & Smelting Co. Ltd, Ageo-shi, Saitama 362-0013 (JP); YAMAMOTO, Takuya, Mitsui Mining & Smelting Co. Ltd, Ageo -shi, Saitama 362-001 (JP); IWAKIRI, K., Mitsui Mining & Smelting Co., Ltd, Ageo-shi, Saitama 362-001 (JP); NAKANO, Osamu, Mitsui Mining & Smelting Co., Ltd, Ageo-shi, Saitama 362-0013 (JP)
(74) Representative: Allard, Susan Joyce
(86) International application number: JP0002759
(87) International publication number: WO0069238

(57) **Abstract**

The present invention provides a method for forming a circuit having conductor lines arranged at fine pitches on a copper-clad laminate, which method solves a problem in that the thickness of a copper layer subjected to etching becomes thick as a result of plating for formation of plated through holes or via holes, to thereby easily form the circuit having conductor lines arranged at fine pitches. In manufacture of a double-sided printed wiring board or a multilayer printed wiring board having three or more layers, involving copper plating for establishing electrical interlayer continuity by means of plated through holes or via holes, a peelable-type copper foil with carrier foil having a peelable carrier foil is used in order to form an external layer of the printed wiring board. The printed wiring board is manufactured by the steps of forming through holes for formation of plated through holes or hole portions for formation of via holes without removal of the peelable carrier foil; performing desmearing and copper plating for establishing electrical interlayer continuity; peeling off the carrier foil; performing registration for an external circuit pattern on the external layer formed of the copper foil; and performing etching.

## Description

### TECHNICAL FIELD

The present invention relates to a method for manufacturing a printed wiring board. More particularly, the invention relates to a technique for manufacturing a printed wiring board, adapted to form a circuit pattern having conductive lines arranged at finer pitches.

### BACKGROUND ART

In recent years, miniaturization of electronic equipment has been accompanied by a tendency for a printed wiring board used therein to assume a multilayer form, and the width of and the space between conductive lines of a circuit pattern of the printed wiring board have become finer. Accordingly, a copper foil used in manufacture of a printed wiring board is strongly required to have a reduced thickness.

A printed wiring board employs a copper-clad laminate, which includes a plurality of prepreg layers and is clad with a copper foil on at least a single side. A prepreg is glass cloth, kraft paper, or nonwoven fabric of glass fiber impregnated with a thermosetting resin, such as phenol resin or epoxy resin, and assumes the form of a semi-cured sheet.

A double-sided printed wiring board employs a copper-clad laminate which employs a prepreg having copper foils on its apposite sides, and is manufactured by the steps of etching the copper foils disposed on the opposite sides of the prepreg so as to form the corresponding predetermined circuits; forming in the copper-clad laminate through holes for formation of plated through holes; and subjecting the copper-clad laminate to desmearing and copper plating so as to establish electrical connection between circuits provided on the opposite surfaces.

A multilayer printed wiring board having three or more layers employs a multilayer laminate which includes an internal-layer core, a prepreg disposed on the internal-layer core, and a copper foil disposed on the prepreg. The internal-layer core assumes the form of a single- or double-sided copper-clad laminate, on which an internal circuit is formed beforehand. Alternatively, the multilayer printed wiring board having three or more layers employs a multilayer laminate which includes a plurality of internal-layer cores, a prepreg sandwiched between each adjacent pair of the internal-layer cores, a prepreg disposed on the outer side of each outermost internal-layer core, and a copper foil disposed on the prepreg disposed on the outer side of each outermost internal-layer core. In order to establish electrical continuity between the internal and external circuits between the internal circuits, hole portions for formation of via holes are formed as appropriate in the internal-layer core or the outermost prepreg, followed by desmearing and copper plating. Also, through-holes are formed as in the case of the above-described double-sided printed wiring board.

Each through hole or via hole formed in the printed wiring board is generally formed by the steps of forming, at a predetermined position and by means of a mechanical drill or a laser, a through hole for formation of a plated through hole or a hole portion for formation of a via hole; and performing electroless plating and electroplating so as to form a copper plating layer of the through hole or via hole.

In order to provide reliable connection, the copper plating layer of a through hole or via hole must have a thickness of about 15-20 µm. When plating is performed so as to form this copper plating layer of a through hole or via hole, the copper plating layer is also formed on a copper foil, which serves as an outermost layer. As a result, a circuit to be formed later assumes the total thickness of the copper foil and the copper plating layer. Such an increase in the thickness of copper to be formed into a circuit causes great difficulty in forming, through etching, a circuit having fine conductive lines; i.e., a fine circuit pattern. Also, the total amount of copper to be etched out increases, resulting in a tendency toward an increase, in etching load.

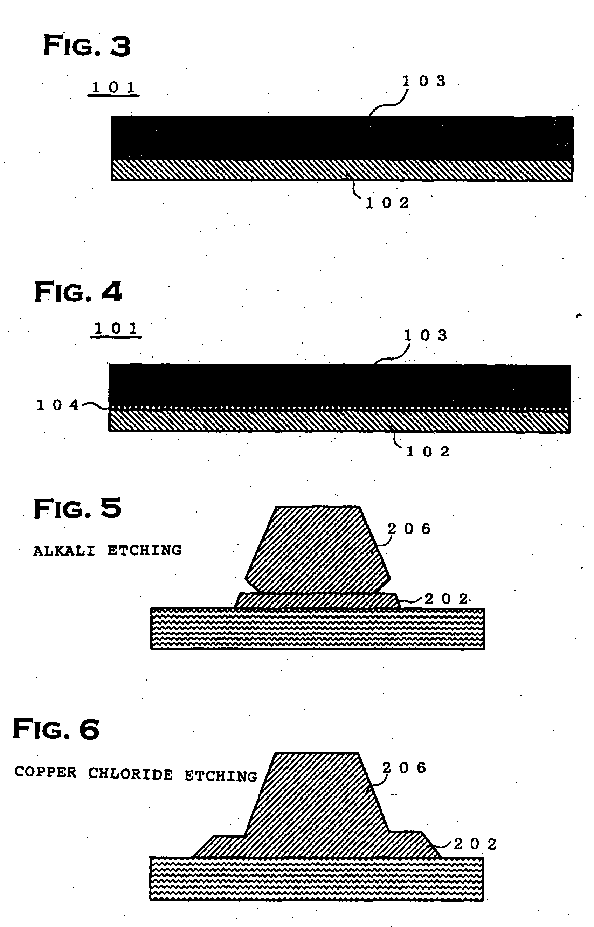

When electroless copper plating is to be performed on through holes for formation of plated through holes or hole portions for formation of via holes, a catalyzing process is usually performed so as to deposit palladium (Pd), which serves as a nucleus for deposition in electroless plating. In order to effect smooth electroless copper plating, the catalyzing process is intended to deposit a metallic catalyst, such as palladium, serving as a nucleus for deposition in electroless plating, on a surface of a prepreg serving as an insulating material; i.e., on an exposed surface of the through hole or the hole portion. As a result of the catalyzing process, palladium is also deposited on the surface of the outermost copper foil. Subsequent electroless plating causes palladium to remain on the interface between the copper foil and the copper plating layer. Such a metallic catalyst is easy to dissolve in alkali and is difficult to dissolve in acid. Thus, when an alkali etchant, which uses, for example, ammonia, is used in forming a circuit through etching, a portion to which a metallic catalyst, such as palladium, adheres; i.e., the interface between the copper plating layer and the copper foil, dissolves selectively as shown in FIG. 5. As a result, the copper plating layer may come off with a resultant breakage of a conductive line. In the case where an acid etchant which contains cupric chloride and hydrochloric acid is employed, the copper plating layer is readily etched, whereas the metallic catalyst, such as palladium, present in the interface hinders the progress of etching on the copper foil side. As a result, there arises a difference in etching rate between the copper plating layer and the copper foil, causing formation of a stepped conductor as shown in FIG. 6 and thus involving a tendency toward the occurrence of a short circuit.

An object of the present invention is to solve the above problems, and to provide a method for manufacturing a double-sided printed wiring board or a multilayer printed wiring board having three or more layers, capable of forming a circuit pattern having conductive lines arranged at fine pitches, exhibiting excellent etching efficiency, and not involving breakage of a conductive line or the occurrence of a short circuit in the course of etching.

### SUMMARY OF THE INVENTION

To achieve the above object, the present inventors carried out extensive studies, and as a result, found a technique for forming a fine circuit, which is not obtained from a conventional manufacturing method, through use of a peelable-type copper foil with carrier foil serving as an external layer in manufacture of a double-sided printed wiring board or a multilayer printed wiring board having three or more layers, involving copper plating for establishing electrical interlayer continuity by means of plated through holes or via holes.

Specifically, in manufacture of a double-sided printed wiring board or a multilayer printed wiring board having three or more layers, involving copper plating for establishing electrical interlayer continuity by means of plated through holes or via holes, a peelable-type copper foil with carrier foil having a peelable carrier is used in order to form an external layer of the printed wiring board. The printed wiring board is manufactured by the steps of forming through holes for formation of plated through holes or hole portions for formation of via holes without release of the peelable carrier foil; desmearing the through holes or the hole portions; plating the through holes or the via holes with copper so as to impart electrical continuity thereto to thereby establish electrical interlayer continuity; peeling off the carrier foil; performing registration for an external circuit pattern on the external layer formed of the copper foil; and performing etching.

According to the present invention, copper plating for establishing electrical interlayer continuity is performed so as to impart electrical continuity to through holes for formation of plated through holes or hole portions for formation of via holes, and subsequently, the carrier foil is peeled away. As a result, a copper plating layer for establishing electrical interlayer continuity is left only on the wall of the through holes or the via holes, and another, unnecessary copper plating layer can be removed. Thus, a circuit is formed from only the copper foil with carrier foil from which the carrier foil has been released. Since the thickness of copper etched for formation of a circuit is equal to that of the copper foil, a circuit having conductor lines arranged at a very fine pitch can be easily formed. Additionally, a manufacturing process subsequent to formation of through holes for formation of plated through holes or hole portions for formation of via holes and ranging from desmearing to copper plating for establishing electrical interlayer continuity is performed while the carrier foil of the copper foil with carrier foil is present, thereby preventing damage to the copper foil which would otherwise result from desmearing, as well as adhesion of a metallic catalyst, such as palladium, to the copper foil which would otherwise result from catalyzing. Thus, a fine circuit can be formed without involvement of a short circuit or breakage of a conductive line. Use of a copper foil with carrier foil enables disposition on a laminate of an ultra thin copper foil having a thickness not greater than 12 µm without involving wrinkling. Further, even when the through holes or the hole portions are formed by means of drilling, a so-called cover plate for drilling is not required to use, because the carrier foil functions as such a cover plate. Moreover, since the carrier foil severs as a cover plate, a work for removing burrs produced during machining is unnecessary, and drilling accuracy can be improved.

Herein, the term "plated through hole" includes a plated through hole which is used to interconnect internal and external circuits and is used as a hole to which a mounted component is fixed and a plated through hole which is provided merely for establishing electrical continuity and into which no terminal of the Component is inserted. The term "via hole" includes an interstitial via hole, such as a blind via hole or a buried via hole, and a through via hole.

### DISCLOSURE OF THE INVENTION

A method according the present invention for manufacturing a double-sided printed wiring board or a multilayer printed wiring board having three or more layers will next be described in detail with reference to the accompanying drawings. First will be described a peelable type copper foil with carrier foil used in the present invention.

FIG. 3 shows a schematic sectional view of a copper foil with carrier foil used in the present invention. In FIG. 3, reference numeral 101 denotes a copper foil with carrier foil; reference numeral 102 denotes a copper foil; and reference numeral 103 denotes a carrier foil. Examples of the carrier foil 103 include a metallic foil, such as a copper foil, a copper alloy foil, an aluminum foil, a composite metallic foil composed of an aluminum foil plated with copper, a composite metallic foil composed of an aluminum foil plated with zinc, or a stainless steel foil; a sheet of a synthetic resin, such as polyimide, polyester, polyurethane, or Teflon; or a sheet of an inorganic material. Particularly, a copper foil is preferred as the carrier foil. This is because, after being peeled off, the carrier foil can be recycled as a copper material. Preferably, the carrier foil 103 has a thickness of 5-200 µm. When the thickness is less than 5 µm, ease of handling of the copper foil with carrier foil becomes poor. When the thickness is in excess of 200 µm, manufacturing cost increases. From the viewpoint of manufacturing cost and ease of handling of the copper foil with carrier foil, the thickness of the carrier foil 103 is preferably 10-70 µm.

The thickness of the copper foil 102 is not particularly limited. According to the method of the present invention for manufacturing a printed wiring board, the thickness of the copper foil 102 of the copper foil with carrier foil 101 becomes that of a circuit formed through etching. Therefore, the thickness of the copper foil 102 may be selected according to the width and thickness of a circuit to be formed. Notably, the copper foil 102 may be thicker than the carrier foil 103.

The peelable-type copper foil with carrier foil 101 used in the present invention is formed such that the copper foil 102 is disposed in a peelable manner on the carrier foil 103. The carrier foil 103 can be removed from the copper foil 102 through application of a certain peeling force thereto. Thus, as shown in FIG. 4, the copper foil with carrier foil 101 used in the present invention may be formed such that an adhesive interface layer 104 is disposed between the carrier foil 103 and the copper foil 102.

The adhesive interface layer 104 is not particularly limited, so long as it can maintain a state in which the copper foil 102 can be bonded to the carrier foil 103 with a bonding strength that does not allow easy separation of the copper foil 102. For example, in the case of a copper foil serving as the carrier foil 103, the adhesive interface layer 104 may be a metal containing material formed from a metal, such as chromium, lead, silver, or nickel; an oxide of such a metal; a sulfide, such as sodium sulfide, potassium sulfide, ammonium sulfide, ammonium polysulfide, or copper sulfide; or a chromate. In the case of an aluminum foil serving as the carrier foil 103, the adhesive interface layer 104 may be a metal containing material formed from, for example, zinc.

From the viewpoint of easy separation of a carrier foil, preferred is an adhesive interface layer which is formed from an organic agent so as to serve as an organic adhesive interface between the copper foil and the carrier foil. When the copper foil with carrier foil employs the above-mentioned metallic adhesive interface layer, heat applied during high. temperature press forming for lamination conceivably causes mutual diffusion between the adhesive interface layer and the carrier foil or the copper foil. As a result, separation of the carrier foil from the copper foil may become difficult, and required peeling force tends to become unstable. When a copper foil with carrier foil employs the organic adhesive interface, heat applied during high-temperature press forming is less likely to cause mutual diffusion between the adhesive interface layer and the carrier foil or the copper foil. The organic adhesive interface subjected to press-forming heat does not result in an increase in adhesive strength, but rather functions as a barrier layer against mutual diffusion between the organic adhesive interface and the carrier foil or the copper foil, thereby facilitating and stabilizing peeling off of the carrier foil.

Preferably, the organic agent contains at least one compound selected from among nitrogen-containing compounds, sulfur-containing compounds, and carboxylic acid. An adhesive interface layer formed from one of these compounds greatly stabilizes the force required to peel off the carrier foil.

Among nitrogen-containing compounds, preferred are those having a substituent (functional group); specifically, orthotriazoles, such as benzotriazole, tolyltriazole, carboxybenzotriazole, and chlorine-substituted benzotriazole; triazole derivatives, such as N',N'-bis(benzotriazolylmethyl)urea (BTD-U); aminotriazoles, such as 3-amino-1H-1,2,4-triazole (ATA), 2-amino-1,3,4-triazole, and 4-amino-1,2,4-triazole; sodium salts of these aminotriazoles; various kinds of salts of amines, such as monoethanolamine, cyclohexylamine, diisopropylamine, and morpholine; imidazoles, such as imidazole, 2-methylimidazole, 2-ethyl-4-methylimidazole, 2-phenylimidazole, and 1-benzyl-2-methylimidazole; and derivatives of these imidazoles. Among these compounds, carboxybenzotriazole (CBTA), N',N'-bis(benzotriazolylmethyl)urea (BTD-U), and 3-amino-1H-1,2,4-triazole (ATA) are particularly preferred.

Sulfur-containing compounds include thiazole, mercaptobenzothiazole, dibenzoazyledisulfide, cyclohexylamine salts of mercaptobenzothiazole, dicyclohexylamine salts of mercaptobenzothiazole, thiocyanuric acid (TCA), and 2-benzimidazolethiol (BIT). Among these compounds, mercaptobenzothiazole and thiocyanuric acid are preferred.

Carboxylic acids include high-molecular-weight carboxylic acid. Among these carboxylic acids, monocarboxylic acids; for example, fatty acids derived from animal or vegetable fat or from oil and fat, are particularly preferred. These carboxylic acids may be saturated or unsaturated. Fatty acids (high-molecular weight monocarboxylic acids) are more particularly preferred; and unsaturated fatty acids, such as oleic acid, linolic acid, and linoleic acid, are further particularly preferred.

The thickness of the above-mentioned organic adhesive interface layer is 10-1000 angstroms, preferably 20-500 angstroms. When the thickness is less than 10 angstroms, the adhesive interface layer fails to assume a uniform thickness, failing to provide stable bond strength. When the thickness is in excess of 1000 angstroms, electrolytic formation of a copper foil on the adhesive interface layer becomes difficult, and the required peeling force tends to decrease.

The copper foil with carrier foil 101, which is used in the present invention, is formed by the steps of forming the adhesive interface layer 104 on the carrier foil 103 as needed; and forming the copper foil 102 by a dry process, such as sputtering or vapor deposition, or by a wet process, such as electrodeposition When the adhesive interface layer is a metallic adhesive interface layer, the adhesive interface layer can be formed on the surface of a carrier foil through electrodeposition by a plating method. When adhesive interface layer is an organic adhesive interface layer, the adhesive interface layer can be formed by the steps of dissolving the above-mentioned organic agent in a solvent; and immersing a carrier foil in the resultant solution, or applying the solution onto the surface of the carrier foil through showering, spraying, dripping, or electrodeposition. When an electrodeposition process is used to form a copper foil on a carrier foil, a plating bath of copper pyrophosphate, a plating bath of copper cyanide, a plating bath of acid copper sulfate, or the like can be used. Among these plating baths, the plating bath of acid copper sulfate is preferred from the viewpoint of practical operation.

Preferably, roughening treatment is performed on the surface of the copper foil 102 of the copper foil with carrier foil 103. Roughening treatment means a surface treatment which is performed to form a surface similar to that formed on general copper foil produced through electrolysis. The roughened surface of the copper foil provides an effect of anchoring the copper foil 102 to a substrate (prepreg), whereby the copper foil does not easily separate from the prepreg.

This roughening treatment is commonly called "nodule-forming treatment," which forms particulate copper electrodeposit on the surface of the copper foil. This roughening treatment is performed by means of electrodeposition using a copper electrolyte and involves two plating processes; namely, burning plating (plating for producing burned deposit) and seal plating (plating for seal). Burning plating is performed, for example, in the following manner. The surface of a copper foil to be roughened is disposed so as to face an electrode. Electrolysis is performed under the following conditions in an electrolyte which contains copper ions.
Copper concentration: 5-30 g/L
Sulfuric acid concentration: 50-150 g/L
Solution temperature: 20-30°C
Current density: 20-40 A/dm²
Time: 5-15 sec

Through electrolysis performed under the above conditions, particulate copper electrodeposit called burned deposit is formed on the surface of the copper foil.

Seal plating is performed, for example, in the following manner. The surface of the copper foil which has undergone burning plating is subjected to electrolysis under the following conditions.
Copper concentration: 40-80 g/L
Sulfuric acid concentration: 50-150 g/L
Solution temperature: 45-55°C
Current density: 20-40 A/dm²
Time: 5-15 sec

Through electrolysis performed under the above conditions, copper is deposited so as to cover the above-mentioned particulate copper electrodeposit (seal plating).

The surface of the copper foil having nodules may further be subjected "whisker-forming plating" as needed. Whisker-forming plating is performed, for example, in the following manner. The surface of the copper foil which has undergone the above nodule-forming treatment is subjected to electrolysis under the following conditions.
Copper concentration: 5-30 g/L
Sulfuric acid concentration: 30-60 g/L
Solution temperature: 20-30°C
Current density: 10-40 A/dm²
Time: 5-15 sec

Through electrolysis performed under the above conditions, whiskers of copper electrodeposit (whisker plating) is formed on the nodule-carrying surface of the copper foil. Whisker-forming plating further improves adhesion of the copper foil to the prepreg.

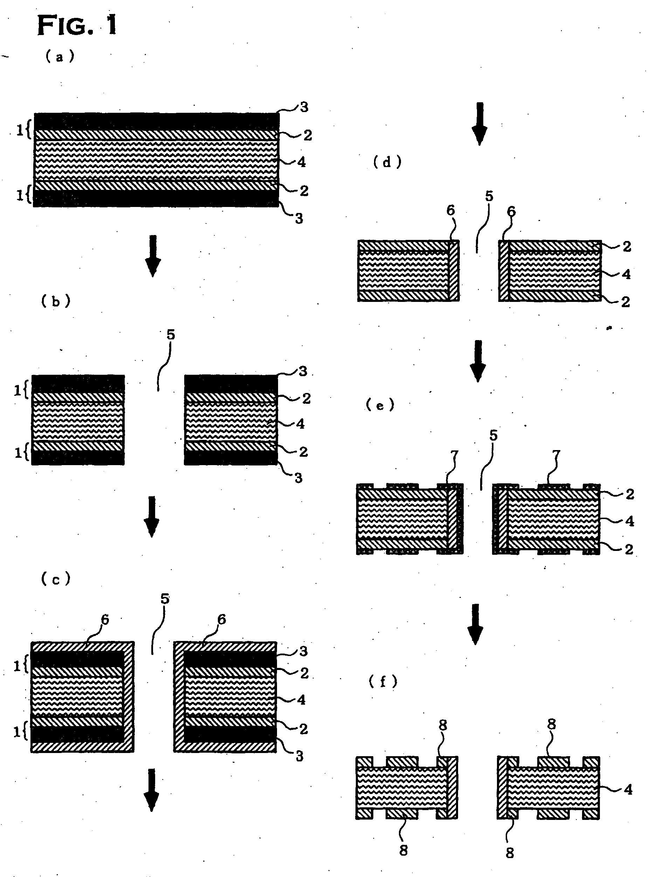

Next, the method according to the present invention for manufacturing a printed wiring board will be described with reference to a printed wiring board in which plated through holes are formed. FIG. 1 schematically shows the steps of forming a plated through hole in the method according to the present invention for manufacturing a printed wiring board. In FIG. 1, reference numeral 1 denotes a copper foil with carrier foil; reference numeral 2 denotes a copper foil; and reference numeral 3 denotes a carrier foil. Reference numeral 4 denotes a prepreg; reference numeral 5 denotes a through hole; reference numeral 6 denotes a copper plating layer; reference numeral 7 denotes a resist pattern; and reference numeral 8 denotes a formed external circuit.

First, according to the present invention, as shown in FIG. 1(a), the copper foil with carrier foils 1 are disposed on the corresponding opposite sides of the prepreg 4 having a predetermined thickness, such that the copper foils 2 face the corresponding surfaces of the prepreg 4, followed by high-temperature press forming so as to manufacture a double-sided laminate. The prepreg 4 used in the present invention is not particularly limited, so long as insulating characteristics required in a printed circuit board are satisfied. Examples of the prepreg 4 include glass epoxy substrate, glass polyimide substrate, glass polyester substrate, aramid epoxy substrate, and composite substrate, such as paper-phenol substrate and paper-epoxy substrate. The prepreg 4 and the copper foil with carrier foils 1 are press-formed usually at a temperature of 150-200°C.

Next, as shown in FIG. 1(b), a through hole 5 is formed in the obtained double-sided laminate in such a manner as to extend between the upper and lower surfaces of the laminate. The formed through hole 5 is to become a "plated through hole." The through hole 5 may be formed by means of, for example, a mechanical drill or a laser. The size of the through hole 5 is determined as appropriate on the basis of printed circuit design while the type of substrate to be used and the thickness of a copper plating layer are taken into account.

Next, as shown in FIG. 1(c), a copper plating layer 6 for establishing electrical interlayer continuity is formed on the wall surface of the through hole 5 and on the upper and lower surfaces of the laminate. The material composition of the copper plating layer 6 is not particularly limited. From the viewpoint of connection reliability, the copper plating layer 6 is preferably of copper or copper alloy. The copper plating layer 6 is formed through electroless copper plating or copper electroplating after desmearing is performed for removing smear from the wall surface of the through hole 5.

The desmearing is performed through, for example, chemical treatment, a liquid honing process, or a plasma process. Specifically, in the chemical treatment, the laminate is immersed in a potassium permanganate solution, a sodium solution, concentrated sulfuric acid, or a chromic acid solution, whereby smear on the wall surface of the through hole 5 is swollen and removed. In the liquid honing process, abrasive grains impinge on the wall surface of the through hole 5 so as to remove smear therefrom. In the plasma process, plasma is used for desmearing. Subsequently, before electroless copper plating is performed, so-called catalyzing is generally performed so as to deposit palladium (Pd), which serves as a nucleus for deposition. In catalyzing, a laminate having through holes formed therein is immersed in an aqueous solution which contains palladium serving as a metallic catalyst. Electroless copper plating can be performed according to a known process. For example, electroless copper plating may be performed by use of an electroless copper plating bath, such as MELPLATE (product of Meltech Corp.). Subsequent copper electroplating is performed by use of a known plating bath, such as a copper pyrophosphate plating bath or a copper sulfate plating bath, usually at a current density of 1-10 A/dm². The thickness of the thus-formed copper plating layer 6 is not particularly limited, but is selected as appropriate on the basis of the thickness of an intended printed wiring board and circuit design.

Next, as shown in FIG. 1(d), the carrier foil 3 of each copper foil with carrier foil 1 is peeled from the copper foil 2, whereby a portion of the copper plating layer 6 on the carrier foil 3 is removed with the carrier foil 3. As a result, the copper foils 2 are respectively exposed on the opposite sides of the prepreg 4. When the carrier foil 3 is peeled away, only a portion of the copper plating layer 6 on the carrier foil 3 is removed. A portion of the copper plating layer 6 on the wall surface of the through hole 5 remains unremoved, thereby establishing electrical continuity between the copper foils 2 disposed on the opposite sides of the prepreg 4.

According to the present invention, after the through hole 5 is formed, the carrier foil 3 is peeled away. Thus, the copper foil 2 to be formed into a circuit is not contaminated with smear (resin powder), which is generated during formation of the through hole 5. Also, the present invention enables drilling of the through hole 5 via the carrier foil 3 without use of a cover plate or a like member which is generally used in drilling. Thus, in drilling, burrs are generated only on the carrier foil 3. Since the carrier foil 3 having burrs is peeled away, the present invention does not involve deburring of the copper foil 2.

Subsequently, as shown in FIG. 1(e), the exposed surface of each of the copper foils 2 is printed with a circuit and is then subjected to etching, yielding a printed wiring board shown in FIG. 1(f). Printing of a circuit is performed according to a known process. For example, photoresist is applied onto the surface of the copper foil 2. Then, a mask on which a predetermined circuit is formed is placed on the applied photoresist, followed by exposure. As a result, exposed portions and unexposed portions are formed on the photoresist surface. Subsequently, development is performed so as to form a resist pattern 7 (FIG. 1(e)). Next, etching is performed by use of an acid etchant which contains cupric chloride and hydrochloric acid, or an alkali etchant, such as aqueous ammonia, so as to remove those portions of the copper foil 2 which are not covered with the resist pattern 7, thereby forming an external circuit 8. Then, the applied photoresist is removed, yielding a printed wiring board (FIG. 1(f)).

The present invention has been described by reference to a double-sided printed wiring board, but is not limited thereto. The above-describe method for forming a plated through hole can be applied to the manufacture of a multilayer printed wiring board having three or more layers.

Thus, the process of the present invention for forming a plated through hole permits the thickness of the copper foil 2, which is formed into a circuit, to become equal to that of the external circuit 8, or an etching depth. Thus, through employment of a sufficiently thin copper foil 2 for the copper foil with carrier foil 1, a circuit having conductive lines arranged at fine pitches can be easily obtained. Also, since a metallic catalyst, such as palladium, does not adhere to the surface of the copper foil 2 to be formed into a circuit, etching does not involve the occurrence of breakage of a conductive line or a short circuit caused by a conductor having a stepped portion as observed in a circuit formed by a conventional method.

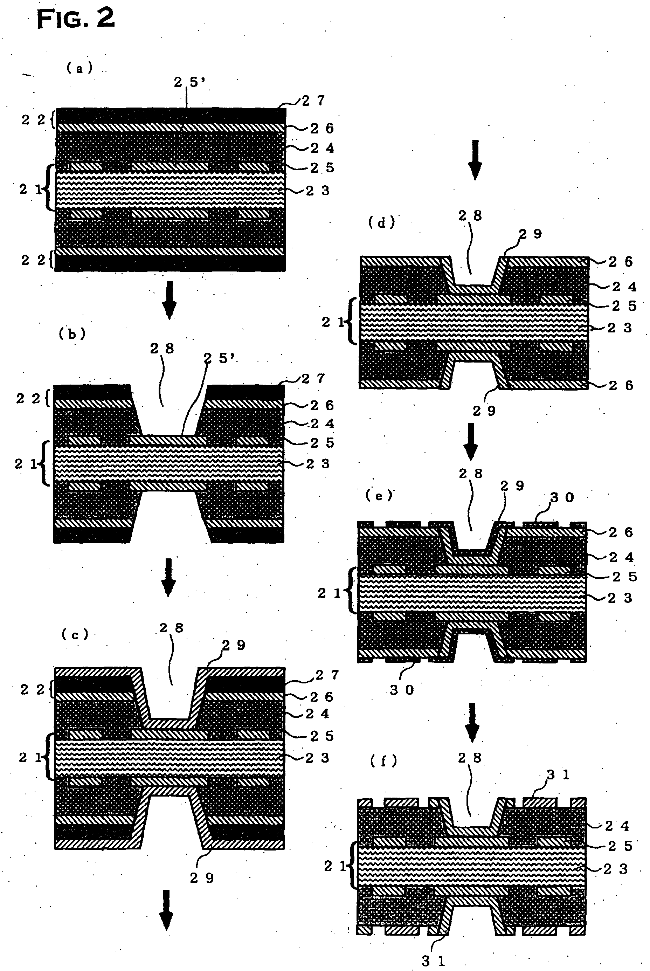

Next, the method according to the present invention for manufacturing a printed wiring board will be described with respect to a printed wiring board in which a via hole is formed. FIG. 2 schematically shows the steps of forming a via in the method according to the present invention for manufacturing a multilayer printed wiring board. In FIG. 2, reference numeral 21 denotes a core material which is used in the present invention and on which an internal circuit is formed; and reference numeral 22 denotes a copper foil with carrier foil, which is used in the present invention. Reference numeral 23 denotes a prepreg; reference numeral 24 denotes a resin layer; reference numeral 25 denotes an internal circuit; reference numeral 26 denotes a copper foil; and reference numeral 27 denotes a carrier foil. Reference numeral 28 denotes a hole portion; reference 29 denotes a copper plating layer; reference numeral 30 denotes a resist pattern; and reference 31 denotes an external circuit.

First, according to the present invention, as shown in FIG. 2(a), the core material 21 bearing internal circuits and the copper foil with carrier foil 22 are subjected to high-temperature press forming while the resin layer 24 is sandwiched therebetween, thereby forming a laminate. The core material 21 is not particularly limited, so long as it is composed of the internal circuits 25 and the prepreg 23. For example, the core material 21 may assumes the form of a double-sided printed wiring board in which plated through holes are formed according to the above-described method of the present invention for manufacturing a printed wiring board. Alternatively, the core material 21 may assumes the form of a previously formed printed wiring board having three or more layers. The copper foil with carrier foil 22 includes a carrier foil and a copper foil, which is disposed on the carrier foil in a peelable manner, as in the case of the above-described method for manufacturing a double-sided printed wiring board (see FIG. 3). The copper foil with carrier foil 22 may further include an adhesive interface layer (see FIG. 4).

The present invention will be described while mentioning a laminate which includes the core material 21, the copper foil with carrier foils 22, and the resin layers 24, each being sandwiched between the core material 21 and the copper foil 22. However, the present invention is not limited thereto. A prepreg may be used in place of the resin layer 24. The core material 21 and the copper foil with carrier foils 22 may be laminated with the resin layers 24 as shown in FIG. 2 according to, for example, the following procedure.

A thermosetting resin varnish is applied onto the surface of the copper foil 26 of the copper foil with carrier foil 22 so as to form the resin layer 24 having a predetermined thickness. The varnished copper foil 22 is heated at a temperature of 140-150°C for 5-20 minutes, whereby the varnished copper foil 22 enters a semi-hardened state, or a so-called B stage. This varnished copper foil 22 assumes a structure similar to that of a resin coated copper (RCC) foil; i.e., a structure obtained through formation of a thermosetting resin layer on an electrolytic copper foil. Hereinafter, a copper foil with carrier foil on which the resin layer 24 is formed is called an RCC-type copper foil with carrier foil.

Epoxy resin (EPICOAT 1001 from Yuka Shell Epoxy Kabushiki Kaisha) may be used as a base resin for the thermosetting resin varnish, from which the resin layer 24 is formed. The thermosetting resin varnish may be formed from an epoxy resin composition obtained through mixing of epoxy resin, dicyandiamide serving as a hardener, 2E4MZ (trade name, product of Shikoku Chemicals Corp.) serving as a hardening accelerator, and methyl ethyl ketone serving as a solvent. Alternatively, as mentioned previously, the resin layer 24 may be formed from a thermosetting resin film, or a prepreg which is formed through impregnation of a fibrous substrate, such as glass cloth or aramid paper, with a thermosetting resin.

In this RCC-type copper foil with carrier foil, the thickness of the resin layer 24 is preferably 20-200 µm. When the thickness of the resin layer 24 is less than 20 µm, required interlayer insulating properties and sufficient adhesion are not obtained. When the thickness is in excess of 200 µm, formation of a via hole of a small diameter becomes difficult.

After the RCC-type copper foil with carrier foils are formed, the RCC-type copper foils with carrier foils are disposed on the corresponding opposite sides of the core material 21 while the resin layer 24 is sandwiched between each of the RCC-type copper foils with carrier foils and the core material 21, followed by high-temperature press forming at a temperature of 150-200°C for lamination. According to the present invention, as shown in FIG. 2(a), the RCC-type copper foil with carrier foils are disposed on the corresponding opposite sides of the core material 21. However, the RCC-type copper foil with carrier foil may be disposed on either side of the core material 21.

Next, as shown in FIG. 2(b), the hole portion 28 is formed so as to extend from the surface of the copper foil with carrier foil 22 to the internal circuit 25 and such that a portion of the internal circuit 25 serving as a bottom land 25' is exposed. This hole portion 28 is adapted to form a "via hole." The hole portion 28 may be formed by means of, for example, a mechanical drill or a laser. The profile of the hole portion 28 is determined as appropriate on the basis of printed circuit design while the type of substrate to be used and the thickness of a copper plating layer are taken into account.

Next, as shown in FIG. 2(c), a copper plating layer 29 for establishing electrical interlayer continuity is formed on the wall surface of the hole portion 5 and on the upper and lower surfaces of the laminate. The material composition of the copper plating layer 29 is not particularly limited. From the viewpoint of connection reliability, the copper plating layer 29 is preferably of copper or copper alloy. The copper plating layer 29 is formed through electroless copper plating or copper electroplating after desmearing for removing smear from the wall surface of the hole portion 28 and catalyzing by use of palladium. Since desmearing, catalyzing, electroless copper plating, and copper electroplating are described previously, their detail descriptions are omitted.

Next, as shown in FIG. 2(d), the carrier foil 27 of each copper foil with carrier foil 22 is peeled from the copper foil 26, whereby a portion of the copper plating layer 29 on the carrier foil 22 is removed with the carrier foil 27. As a result, the copper foil 26 disposed on the surface of the resin layer 24 is exposed. When the carrier foil 27 is peeled away, only a portion of the copper plating layer 29 on the carrier foil 27 is removed. A portion of the copper plating layer 29 on the wall surface of the hole portion 28 and on the bottom land surface remains unremoved, thereby establishing electrical continuity between the internal circuit (25 or 25') and the external copper foil 26.

According to the present invention, after the hole portion 28 is formed, the carrier foil 27 is peeled away. Thus, the copper foil 26 is not contaminated with smear (resin powder), which is generated during formation of the hole portion 28. Also, even when via holes are formed, the present invention does not require use of a cover plate which is generally used in drilling. Further, since drilling of the hole portion 28 can be performed via the carrier foil 27, burrs are only generated on the carrier foil 27 in drilling. Since the carrier foil 27 having burrs is peeled away, the present invention does not involve deburring of the copper foil 26 in contrast to a conventional method which involves the deburring process.

Subsequently, as shown in FIG. 2(e), the exposed surface of each of the copper foils 26 is printed with a circuit and is then subjected to etching, yielding a multilayer printed wiring board shown in FIG. 2(f). Printing of a circuit is performed, for example, in the following manner. Photoresist is applied onto the surface of the copper foil 26. Then, a mask on which a predetermined circuit is formed is placed on the applied photoresist, followed by exposure. As a result, exposed portions and unexposed portions are formed on the photoresist surface. Subsequently, development is performed so as to form a resist pattern 30 (FIG 2(e)). Next, etching is performed by use of an acid etchant which contains cupric chloride and hydrochloric acid, or an alkali etchant, such as aqueous ammonia, so as to remove those portions of the copper foil 26 which are not covered with the resist pattern 30, thereby forming an external circuit 31. Then, the applied photoresist is removed, yielding a multilayer printed wiring board (FIG. 2(f)).

Thus, the process of the present invention for forming a via hole permits the thickness of the copper foil 26, which is formed into a circuit, to become equal to that of the external circuit 31, or an etching depth. Thus, through employment of a thinner copper foil 26 for the copper foil with carrier foil 22, a circuit having conductive lines arranged at fine pitches can be easily obtained. Also, since a metallic catalyst, such as palladium, does not adhere to the surface of the copper foil 26 to be formed into a circuit, etching does not involve the occurrence of breakage of a conductive line or a short circuit caused by a conductor having a stepped portion as observed in a circuit formed by a conventional method.

### BRIEF DESCRIPTION OF THE DRAWINGS

FIG. 1 is a series of schematic sectional views showing an embodiment of a method for manufacturing a double-sided printed wiring board according to the present invention; FIG. 2 is a series of schematic sectional views showing an embodiment of a method for manufacturing a multilayer printed wiring board according to the present invention; FIG. 3 is a schematic sectional view showing an embodiment of a copper foil with carrier foil used in the present invention; FIG. 4 is a schematic sectional view showing another embodiment of a copper foil with carrier foil used in the present invention; FIG. 5 is a schematic sectional view of a circuit of a printed wiring board formed through alkali etching in a conventional method; and FIG. 6 is a schematic sectional view of a circuit of a printed wiring board formed through copper chloride etching in a conventional method.

### DESCRIPTION OF REFERENCE NUMERALS

1, 22, 101: copper foil with carrier foil
2, 26, 102, 202: copper foil
3, 27, 103: carrier foil
4, 23, 104: prepreg
5: through hole (plated through hole)
6, 29, 206: copper plating layer
7, 30: resist pattern
8, 31: external circuit
21: core material
24: resin layer
25: internal circuit
25': bottom land
28: hole portion (via hole)

### BEST MODE FOR CARRYING OUT THE INVENTION

Embodiments of the present invention will next be described by way of examples 1 and 2.

### Example 1

A copper foil with carrier foil, which included a copper foil having a thickness of 18 µm and a copper carrier foil having a thickness of 35 µm (an adhesive interface layer was formed by use of thiocyanuric acid and BTA so as to serve as an organic adhesive interface), was disposed on each side of a prepreg of glass epoxy having a thickness of 0.3 mm such that the surface of the 18 µm-thick copper foil served as an adhesive surface. The thus-formed laminate was pressed at high temperature, yielding a double-sided copper clad laminate.

Through holes for formation of plated through holes was formed in the double-sided laminate by means of a drill having a diameter of 0.8 mm. Subsequently, the double-sided laminate sequentially underwent desmearing, catalyzing by use of palladium, electroless copper plating, and copper electroplating, thereby forming a copper plating layer having a thickness of 20 µm on the wall surface of the through holes and the surfaces of the carrier foils. Then, end portions of the double-sided laminate were cut, and the carrier foils and the copper plating layers formed on the corresponding carrier foils were peeled away. The copper plating layer on the wall surfaces of the through holes was cut in the vicinity of the adhesive interface layers. However, it was confirmed that the copper plating layer for establishing electrical continuity between the copper foils disposed on the opposite sides of the prepreg remained intact.

The resultant copper-clad laminate was covered with a photosensitive dry film serving as an etching resist. A pattern forming film bearing a circuit pattern of L (line width)/S (space) = 70 µm/70 µm was placed on the photosensitive dry film. The photosensitive dry film was subjected to exposure and development. Then, etching was performed by use of a copper chloride etchant so as to form a circuit, yielding a double-sided printed wiring board. Observation of the thus-obtained double-sided printed wiring board revealed that the sectional profile of the formed circuit had a high etch factor.

### Example 2

Two prepreg sheets of glass epoxy having a thickness of 0.18 mm was disposed on each side of a core material on which an internal circuit (including a bottom land for a via hole) had been formed beforehand. A copper foil with carrier foil, which included a copper foil having a thickness of 5 µm and a copper carrier foil having a thickness of 35 µm (an adhesive interface layer was formed by use of carboxybenzotriazole), was disposed on each prepreg, which was disposed on the core material, such that the surface of the 5 µm-thick copper foil served as an adhesive surface. The thus-formed laminate was pressed at high temperature, yielding a multilayer laminate.

Hole portions (via holes) each having a diameter of 0.2 mm were formed in the thus-obtained multilayer laminate by use of a carbon dioxide gas laser so as to extend from the surface of the copper foil with carrier foil to the bottom land formed on the core material and such that the bottom land was exposed. Subsequently, the multilayer laminate sequentially underwent desmearing, catalyzing by use of palladium, electroless copper plating, and copper electroplating, thereby forming a copper plating layer having a thickness of 15 µm on the wall surfaces of the hole portions and the surfaces of the carrier foils. Then, end portions of the multilayer laminate were cut, and the carrier foils and the copper plating layers formed on the corresponding carrier foils were peeled away. The copper plating layer on the wall surfaces of the hole portions was cut in the vicinity of the adhesive interface layers. However, it was confirmed that the copper plating layer for establishing electrical continuity between the external copper foil disposed on the surface of the prepreg and the bottom land formed on the core material remained intact.

The resultant copper-clad multilayer laminate was coated with a liquid resist. A pattern forming film bearing a circuit pattern of L/S = 30 µm/30 µm was placed on the liquid resist coating, followed by exposure and development. Then, etching was performed by use of a copper chloride etchant so as to form an external circuit, yielding a multilayer printed wiring board. Observation of the thus obtained multilayer printed wiring board revealed that the sectional profile of the formed circuit had a high etch factor.

### INDUSTRIAL APPLICABILITY

According to the present invention, copper plating for establishing electrical interlayer continuity is performed so as to impart electrical continuity to through holes for formation of plated through holes or hole portions for formation of via holes, and subsequently the carrier foil is peeled away. As a result, a copper plating layer for establishing electrical interlayer continuity is left only on the wall of the through holes or the via holes, and another, unnecessary copper plating layer can be removed. Thus, a circuit is formed from only the copper foil with carrier foil from which the carrier foil has been removed. Since the thickness of copper etched for formation of a circuit is equal to that of the copper foil, a circuit having conductor lines arranged at a very fine pitch can be formed. Additionally, a manufacturing process subsequent to formation of through holes for formation of plated through holes or hole portions for formation of via holes and ranging from desmearing to copper plating for establishing electrical interlayer continuity is performed while the carrier foil of the copper foil with carrier foil is present, thereby preventing damage to the copper foil which would otherwise result from desmearing, as well as adhesion of a metallic catalyst, such as palladium, to the copper foil which would otherwise result from catalyzing. Thus, a fine circuit can be formed without involvement of a short circuit or breakage of a conductive line. Use of a copper foil with carrier foil enables disposition on a laminate of an ultra thin copper foil having a thickness not greater than 12 µm without involvement of wrinkling. Further, even when the through holes or the hole portions are formed by means of drilling, a so-called cover plate for drilling is not required to use, because the carrier foil functions as such a cover plate. Moreover, since the carrier foil severs as a cover plate, a work for removing burrs produced during machining is unnecessary, and drilling accuracy can be improved.

## Claims

1. A method for manufacturing a double-sided printed wiring board or a multilayer printed wiring board having three or more layers, involving copper plating for establishing electrical interlayer continuity by means of plated through holes or via holes, said method being characterized by:
using a peelable-type copper foil with carrier foil having a peelable carrier foil in order to form an external layer of the printed wiring board;
forming through holes for formation of plated through holes or hole portions for formation of via holes without removal of the peelable carrier foil;
desmearing the through holes or the hole portions;
plating the through holes or the via holes with copper so as to impart electrical continuity thereto to thereby establish electrical interlayer continuity;
peeling off the carrier foil;
performing registration for an external circuit pattern on the external layer formed of the copper foil; and
performing etching.

2. A method for manufacturing a double-sided printed wiring board or a multilayer printed wiring board having three or more layers as defined in claim 1, wherein the peelable-type copper foil with carrier foil comprises an adhesive interface layer sandwiched between the carrier foil and the copper foil.

3. A method for manufacturing a double-sided printed wiring board or a multilayer printed wiring board having three or more layers as defined in claim 1 or 2, wherein the carrier foil is formed of a copper foil.

4. A method for manufacturing a double-sided printed wiring board or a multilayer printed wiring board having three or more layers as defined in claim 2 or 3, wherein the adhesive interface layer is an organic adhesive interface which is formed by use of an organic agent.

5. A method for manufacturing a double-sided printed wiring board or a multilayer printed wiring board having three or more layers as defined in claim 4, wherein the organic agent is formed from at least one compound selected from among nitrogen-containing, compounds, sulfur-containing compounds, and carboxylic acid.
